# EUROPÄISCHE PATENTSCHRIFT

(11) **EP 1 546 949 B1**
(45) Veröffentlichungstag und Bekanntmachung des Hinweises auf die Patenterteilung: **05.04.2006**
(21) Anmeldenummer: 03794896.5
(22) Anmeldetag: 19.08.2003
(51) Int. Cl.: G06F 17/50

(54) **VERFAHREN UND VORRICHTUNG ZUR VERIFIKATION VON DIGITALEN SCHALTUNGEN**
METHOD AND DEVICE FOR VERIFYING DIGITAL CIRCUITS
PROCEDE ET DISPOSITIF DE VERIFICATION DE CIRCUITS NUMERIQUES

(30) Priorität: 29.08.2002 DE 10239782
(43) Veröffentlichungstag der Anmeldung: 29.06.2005
(73) Patentinhaber: Onespin Solutions GmbH, 80339 München (DE)
(72) Erfinder: HÖRETH, Stefan, 85625 Glonn (DE); MÜLLER-BRAHMS, Martin, 81475 München (DE); RUDLOF, Thomas, West Linn, OR 97068 (US)
(74) Vertreter: Hofmann, Harald
(86) Internationale Anmeldenummer: PCT/EP2003/009179
(87) Internationale Veröffentlichungsnummer: WO 2004/025520

(56) Entgegenhaltungen:
- STOFFEL D ET AL: "Verification of integer multipliers on the arithmetic bit level" IEEE/ACM INTERNATIONAL CONFERENCE ON COMPUTER AIDED DESIGN. ICCAD 2001. IEEE/ACM DIGEST OF TECHNICAL PAPERS (CAT. NO.01CH37281), IEEE/ACM INTERNATIONAL CONFERENCE ON COMPUTER AIDED DESIGN. ICCAD 2001. IEEE/ACM DIGEST OF TECHNICAL PAPERS, SAN JOSE, CA, Seiten 183-189, XP002270149 2001, Piscataway, NJ, USA, IEEE, USA ISBN: 0-7803-7247-6
- YING-TSAI CHANG ET AL: "Induction-based gate-level verification of multipliers" IEEE/ACM INTERNATIONAL CONFERENCE ON COMPUTER AIDED DESIGN. ICCAD 2001. IEEE/ACM DIGEST OF TECHNICAL PAPERS (CAT. NO.01CH37281), IEEE/ACM INTERNATIONAL CONFERENCE ON COMPUTER AIDED DESIGN. ICCAD 2001. IEEE/ACM DIGEST OF TECHNICAL PAPERS, SAN JOSE, CA, Seiten 190-193, XP002270150 2001, Piscataway, NJ, USA, IEEE, USA ISBN: 0-7803-7247-6
- JIUNN-CHERN CHEN ET AL: "Equivalence checking of integer multipliers" PROCEEDINGS OF THE ASP-DAC 2001. ASIA AND SOUTH PACIFIC DESIGN AUTOMATION CONFERENCE 2001 (CAT. NO.01EX455), PROCEEDINGS OF THE ASP-DAC 2001. ASIA AND SOUTH PACIFIC DESIGN AUTOMATION CONFERENCE 2001, YOKOHAMA, JAPAN, 30 JAN.-2 FEB. 2001, Seiten 169-174, XP002270151 2001, Piscataway, NJ, USA, IEEE, USA ISBN: 0-7803-6633-6

## Beschreibung

Die vorliegende Erfindung betrifft ein Verfahren sowie eine entsprechend ausgestaltete Vorrichtung und ein entsprechend ausgestaltetes Computerprogramm-Produkt zur Verifikation von digitalen Schaltungen, insbesondere von digitalen Schaltungen mit Multipliziererstrukturen.

Multipliziererstrukturen oder Multiplikationsfunktionen werden bekanntermaßen weitläufig in digitalen Schaltungen, wie z.B. für Prozessoren, digitale Signalprozessoren (DSP) oder Graphikchipsets etc., verwendet. Ein Fehler in einem Chip mit einer Multiplikationsfunktion kann - wie auch Fehler in anderen Schaltungsstrukturen - einen Ausfall des gesamten Chips zur Folge haben.

Daher kommt der Verifikation von digitalen Schaltungen, nachdem diese beispielsweise computergestützt mit Hilfe eines Synthesetools entwickelt worden sind, größte Bedeutung zu. In letzter Zeit hat diesbezüglich die so genannte Äquivalenzprüfung immer mehr an Bedeutung gewonnen. Dabei wird überprüft, inwieweit die in der digitalen Schaltung implementierten Funktionen mit den durch eine Referenzbeschreibung, z.B. einer RTL-("Register Transfer Level"), VHDL-("Very High Speed IC HW Description Language") oder Verilog-Beschreibung, beschriebenen Schaltungsstrukturen bzgl. ihrer Funktionsweise äquivalent sind oder nicht. Moderne Äquivalenzprüfer können digitale Schaltungen mit mehreren Millionen Gattern verarbeiten. Dabei liefern die Äquivalenzprüfer insbesondere dann sehr gute Ergebnisse, wenn die miteinander zu vergleichenden Schaltungsentwürfe, d.h. die zu verifizierende digitale Schaltung und die ihr zugrunde liegende Referenzschaltungsbeschreibung, ein hohes Maß an struktureller Ähnlichkeit aufweisen. Dagegen liefert eine Äquivalenzprüfung keine zufrieden stellenden Ergebnisse, falls sich die zu verifizierende digitale Schaltung und die zugrunde liegende Referenzbeschreibung strukturell mehr oder weniger deutlich unterscheiden und somit nur wenige interne Äquivalenzen aufweisen.

Dabei gilt die formale Verifikation von Multipliziererstrukturen bzw. Multiplikationsfunktionen als eines der schwierigsten Probleme bei der Äquivalenzprüfung von digitalen Schaltungen.

Es ist bekannt, dass dezimale Zahlen A und B auf verschiedene Art und Weise miteinander multipliziert werden können. So kann beispielsweise das Produkt A x B oder das Produkt B x A gebildet werden. Zudem kann bekannter Weise das Produkt dadurch gebildet werden, dass die einzelnen Ziffern der beiden dezimalen Zahlen miteinander multipliziert und anschließend die Summe der daraus resultierenden Teilprodukte gebildet wird. Die Reihenfolge, in welcher die Teilprodukte miteinander addiert werden, kann sich von Fall zu Fall unterscheiden, ohne dass selbstverständlich ein anderes Multiplikationsergebnis der Zahlen A und B erhalten wird. Abhängig davon, welcher Ansatz für die Multiplikation der Zahlen A und B gewählt wird, kann für die Implementierung der entsprechenden Multipliziererstruktur eine von verschiedenen möglichen Implementierungsalternativen oder Implementierungsvarianten zum Einsatz kommen, wobei all diese verschiedenen Implementierungsvarianten zwar dasselbe Multiplikationsergebnis liefern, jedoch hinsichtlich ihrer Struktur möglicherweise keine oder nur wenige interne Äquivalenzen aufweisen. Darüber hinaus können selbstverständlich auch unterschiedliche Architekturen für die Implementierung von Multipliziererstrukturen verwendet werden.

Erschwerend kommt hinzu, dass Multiplikationsfunktionen in digitalen Schaltungen in der Regel nicht isoliert auftreten, sondern in Umgebungslogik eingebettet sind. Dabei ist u.U. sogar zu berücksichtigen, dass die Grenzen der Multiplikationsfunktionen - z.B. aufgrund von Schaltungsoptimierungen - nur noch unvollständig gegeben sind ("Sea of Gates") und damit unter formalen Gesichtspunkten die Multiplikationsfunktionen u.U. nicht mehr (explizit) vorhanden sind.

Bislang ist kein Verfahren bekannt, mit dem eine Erkennung von Multipliziererstrukturen innerhalb digitaler Schaltungen zuverlässig und schnell durchgeführt werden kann. Aufgrund der funktionalen Optimierungsmöglichkeiten moderner Syntheseverfahren beim Entwurf von digitalen Schaltungen scheiden beispielsweise einfache "Pattern-Matching"-Ansätze, bei denen es einfach um den Vergleich der Schaltungsstruktur mit einer Referenzschaltungsstruktur geht, aus. Bzgl. der Verifikation von Multipliziererstrukturen sind verschiedene konkurrierende Ansätze bekannt.

Die einfachste Vorgehensweise, welche auch als generischer Ansatz bezeichnet werden kann, sieht vor, den in einer digitalen Schaltung enthaltenen Multipliziererstrukturen keinerlei Sonderbehandlung zukommen zu lassen, so dass vor der Verifikation der digitalen Schaltung in Form einer Äquivalenzprüfung keine explizite Erkennung der in der digitalen Schaltung enthaltenen Multipliziererstrukturen oder Multiplikationsfunktionen notwendig ist. Der mit dieser Vorgehensweise verbundene Nachteil ist jedoch, dass bei der Äquivalenzprüfung häufig lange Laufzeiten auftreten und es ggf. sogar zum Scheitern der Verifikation kommen kann. Das Laufzeitverhalten der Äquivalenzprüfung hängt stark von der (zufälligen) Wahl der Implementierungsalternative für die einzelnen Multipliziererstrukturen, welche der Äquivalenzprüfung zugrunde gelegt wird, ab.

Gemäß einem weiteren Ansatz für die Verifikation von Multipliziererstrukturen wird von dem Anwender vor Durchführung der Äquivalenzprüfung für jede einzelne Multipliziererstruktur oder Multiplikationsfunktion die konkret gewählte Implementierungsalternative festgelegt, d.h. spezifiziert. Das mit diesem Ansatz verbundene Problem ist jedoch, dass dieses Wissen zum Zeitpunkt der Verifikation häufig nicht (mehr) vorhanden ist. Werden von dem Anwender vor Durchführung der Äquivalenzprüfung falsche Angaben gemacht und demzufolge falsche Implementierungsalternativen der Äquivalenzprüfung zugrunde gelegt, besitzt dieser Ansatz dieselben Nachteile wie bei dem zuvor beschriebenen generischen Verifikationsverfahren.

Schließlich sind aus dem Stand der Technik auch verschiedene Verifikationsverfahren bekannt, welche auf einzelne, isoliert betrachtete Multiplikationsfunktionen oder Multipliziererstrukturen beschränkt sind, d.h. die zu verifizierende Implementierung der digitalen Schaltung sowie die damit zu vergleichende Referenzbeschreibung bestehen lediglich aus der Multiplikation selbst. So ist beispielsweise aus "Inductionbased Gate-level Verification of Multipliers", Y.T. Chang und K.-T. Cheng, International Conference on Computer-Aided Design (ICCAD), S. 190ff, 2001 bekannt, durch einen induktionsbasierten Ansatz die Verifikation von n-Bit-Multiplizieren in n Teiläquivalenzprüfungen zu zerlegen. In "Equivalence Checking of Integer Multipliers", J.-C. Chen und Y.-A. Chen, A-sian-Pacific Design Automation Conference (ASPDAC), 2001 wurde vorgeschlagen, beispielsweise nxn-Array-Multiplizierer oder nxn-Wallace-Baum-Multiplizierer über so genannte "Multiplicative Power Hybrid Decision Diagrams" (*PHDD) in Form einer Darstellung auf Datenwort-Ebene darzustellen, um die Äquivalenz von zwei ganzzahligen Multiplizierern zu überprüfen. Des Weiteren ist in dieser Druckschrift auch die Darstellung von ganzzahligen Multiplizierern auf Bitebene in Form von so genannten "Binary Decision Diagrams" (BDD) oder auf Datenwort-Ebene in Form von so genannten "Multiplicative Binary Moment Diagrams" (*BMD) bekannt. Schließlich wird in "Verification of Integer Multipliers on the Arithmetic Bitlevel", D. Stoffel und W. Kunz, International Conference on Computer-Aided Design (ICCAD), S. 183-189, 2001 vorgeschlagen, zur Verifikation von ganzzahligen Multiplizierern einen Boolschen Mapping- oder Abbildungsalgorithmus anzuwenden, welcher aus einer Gatternetzliste einer Addiererschaltung ein Netz von Halbaddierern extrahiert, um anschließend mit Hilfe einfacher arithmetischer Operationen eine Äquivalenzprüfung bei bekannter arithmetischer Darstellung auf Bitebene der Addiererschaltung durchführen zu können. Der in dieser Druckschrift vorgeschlagene Ansatz beruht auf der bereits zuvor beschriebenen Erkenntnis, dass sich ganzzahlige Multiplikationen im Wesentlichen in zwei Abschnitte unterteilen lassen, nämlich einerseits die Bildung von Teilprodukten und andererseits die Addition der Teilprodukte zum schlussendlichen Multiplikationsergebnis.

Wie bereits erwähnt worden ist, sind die zuletzt beschriebenen Verifikationsverfahren jeweils auf einzelne, isolierte Multiplikationsfunktionen beschränkt. Diese Verifikationsverfahren scheiden in der Praxis jedoch zur Verifikation von digitalen Schaltungen, d.h. von Syntheseergebnissen, aus, da die Multiplikationsfunktionen meist nicht isoliert vorhanden sind.

Aus dem Stand der Technik sind somit keine praktikablen Verfahren zur Verifikation von in digitalen Schaltungen implementierten Multipliziererstrukturen oder Multiplikationsfunktionen bekannt. Die Leistungsfähigkeit der aus dem Stand der Technik bekannten Verifikationsverfahren hängt in der Regel stark von der konkreten Implementierung der jeweiligen Multiplikationsfunktion ab. Nach dem Stand der Technik sind daher zusätzliche Informationen über Art und Aufbau der Multipliziererstrukturen in der zu verifizierenden digitalen Schaltung für eine effiziente Verifikation unabdingbar.

Der vorliegenden Erfindung liegt somit die Aufgabe zugrunde, ein effektives Verfahren zur Verifikation von digitalen Schaltungen sowie eine entsprechend ausgestaltete Vorrichtung bereitzustellen, womit die zuvor beschriebenen Probleme beseitigt werden können und insbesondere auch komplexe digitale Schaltungen mit Multipliziererstrukturen durch eine Äquivalenzprüfung verifiziert werden können, ohne dass explizit Informationen über die in der digitalen Schaltung realisierten Implementierungsalternativen der Multipliziererstrukturen bekannt sind oder die Verifikation auf lediglich eine konkrete Implementierungsalternative der Multipliziererstrukturen beschränkt ist.

Diese Aufgabe wird durch ein Verifikationsverfahren mit den Merkmalen des Anspruches 1 bzw. eine Verifikationsvorrichtung mit den Merkmalen des Anspruches 14 gelöst. Des Weiteren wird ein Computerprogramm-Produkt mit einem Programmcode zur Durchführung des erfindungsgemäßen Verifikationsverfahrens, wenn das Programm auf einem Computer- oder Rechnersystem abläuft, mit den Merkmalen des Anspruches 16 und ein digitales Speichermedium, z.B. eine Diskette oder CD-ROM, mit elektronisch auslesbaren Steuersignalen zur Durchführung des erfindungsgemäßen Verifikationsverfahren bei Zusammenwirken mit einem Rechnersystem nach Anspruch 17 bereitgestellt. Die Unteransprüche definieren jeweils bevorzugte und vorteilhafte Ausführungsformen der vorliegenden Erfindung.

Erfindungsgemäß wird vorgeschlagen, zur Verifikation einer digitalen Schaltung zunächst festzustellen bzw. zu entscheiden, welche von mehreren vordefinierten Implementierungsalternativen bestimmter Schaltungsstrukturen in der zu verifizierenden Implementierung der digitalen Schaltung verwendet werden. Hierzu können die verschiedenen vorgegebenen Implementierungsalternativen für die entsprechenden Schaltungsstrukturen innerhalb ihrer Einbettung in der Referenzbeschreibung der digitalen Schaltung, welche bei der Äquivalenzprüfung mit der Implementierung der digitalen Schaltung zu vergleichen ist, simuliert und mit einer Simulation der Implementierung der digitalen Schaltung verglichen werden. Die Simulierung der verschiedenen Implementierungsalternativen kann dabei parallel erfolgen.

Für jede bestimmte Schaltungsstruktur der digitalen Schaltung wird auf diese Weise diejenige Implementierungsalternative bestimmt, deren Simulation den größten Grad an Übereinstimmung mit der Simulation der zu verifizierenden Implementierung der digitalen Schaltung aufweist.

Anschließend können in die auf diese Weise ermittelten Implementierungsalternativen dieser Schaltungsstrukturen in die entsprechende Referenzbeschreibung als Ersatz für die darin enthaltene Beschreibung dieser Schaltungsstrukturen eingesetzt werden, um mit der auf diese Art und Weise geänderten Referenzbeschreibung die eigentliche Äquivalenzprüfung durchzuführen, d.h. es wird dann die geänderte Referenzbeschreibung mit der zu verifizierenden Implementierung der digitalen Schaltung verglichen. Die in die Referenzbeschreibung eingesetzten Implementierungsalternativen für die bestimmten Schaltungsstrukturen können abschließend mit einem speziellen Verfahren separat verifiziert werden.

Erfindungsgemäß wird somit vorgeschlagen, bei der Äquivalenzprüfung bzw. beim Äquivalenzvergleich einer Referenzschaltung, welche kritische Teilstrukturen enthält, mit einer Implementierung der Schaltung zunächst festzustellen bzw. zu entscheiden, welche der bekannten Implementierungsalternativen der kritischen Teilstrukturen in der zu verifizierenden Implementierung der digitalen Schaltung verwendet werden bzw. welche der bekannten Implementierungsalternativen der verwendeten Implementierung strukturell am ähnlichsten ist. Strukturelle Ähnlichkeit ist definitionsgemäß gegeben, wenn eine Implementierungsalternative - nachdem sie in den Kontext der Referenzbeschreibung eingesetzt wurde - viele interne Berechnungspunkte besitzt, zu denen identische interne Berechnungspunkte in der zu verifizierenden Implementierung existieren. Dabei wird der Grad der strukturellen Ähnlichkeit der Implementierungsalternativen mit der tatsächlich verwendeten Implementierung durch ein simulationsbasiertes Verfahren ermittelt, dessen Komplexität nur linear von der Größe der digitalen Schaltung abhängt. Dies kann dadurch geschehen, dass für eine feste Anzahl zufällig erzeugter Eingangsbelegungen der digitalen Schaltung die Werte an allen internen Berechnungspunkten der digitalen Schaltung berechnet werden ("Random Pattern"-Simulation), was sowohl für alle bekannten Implementierungsalternativen von kritischen Teilstrukturen im Kontext der Referenzbeschreibung als auch für die gesamte Implementierung der digitalen Schaltung geschieht.

Anstelle einer Feststellung der absoluten Übereinstimmung von internen Berechnungspunkten der Implementierungsalternativen der kritischen Teilstrukturen mit internen Berechnungspunkten der zu verifizierenden Implementierung der digitalen Schaltung wird vorteilhafterweise lediglich die Übereinstimmung der Berechnungspunkte auf allen zufällig erzeugten Eingangsbelegungen gemessen. Dieses statistische Verfahren reicht aus, um zu jeder kritischen Teilstruktur die zur Implementierung strukturell ähnlichste Implementierungsalternative zu ermitteln.

Generell sind Teilstrukturen einer Referenzschaltung kritisch, wenn es mehrere mögliche funktional gleiche, aber strukturell stark unterschiedliche Implementierungsalternativen für diese Teilstrukturen gibt. Multipliziererstrukturen sind ein häufig auftretendes Beispiel solcher kritischer Teilstrukturen. Für die Anwendbarkeit des zuvor beschriebenen Verfahrens müssen somit lediglich die möglichen Implementierungsalternativen der kritischen Teilstrukturen bekannt sein, während jedoch nicht bekannt sein muss, welche Implementierungsalternative in der zu verifizierenden Implementierung der digitalen Schaltung tatsächlich verwendet wurde.

Um effizient, d.h. mit einem lediglich linear von der Größe der digitalen Schaltung abhängigen Aufwand, ermitteln zu können, welche internen Berechnungspunkte der Implementierungsalternativen auf allen simulierten Mustern mit internen Berechnungspunkten der zu verifizierenden Implementierung übereinstimmen, kann ein Verfahren der Äquivalenzklassenverfeinerung eingesetzt werden. Dabei werden jeweils alle internen Berechnungspunkte, deren Nichtübereinstimmung noch nicht nachgewiesen wurde, zu einer Äquivalenzklasse zusammengefasst. Nach der Simulation einer zufällig erzeugten Eingangsbelegung der digitalen Schaltung wird jede Äquivalenzklasse in Teilklassen aufgesplittet, deren Elemente auf der simulierten Eingangsbelegung übereinstimmen. Interne Beobachtungspunkte, die nach einer festen Anzahl von Simulationsschritten noch in der gleichen Äquivalenzklasse liegen, werden als gleich gewertet.

Bei den bestimmten Schaltungsstrukturen oder kritischen Teilstrukturen, für welche auf zuvor beschrieben Art und Weise diejenigen Implementierungsalternativen bestimmt werden, deren Simulation den größten Übereinstimmungsgrad mit der Simulation der digitalen Schaltung aufweisen, kann es sich insbesondere um Multiplikationsfunktionen oder Mulitpliziererstrukturen handeln, welche - wie zuvor beschrieben worden ist - mit herkömmlichen Verfahren nicht oder nur unzureichend verifiziert werden können. Selbstverständlich ist die vorliegende Erfindung jedoch nicht auf die Verifikation bzw. Erkennung von Multipliziererstrukturen in digitalen Schaltungen beschränkt, sondern kann im Prinzip für alle Arten von Schaltungsstrukturen angewendet werden, für welche verschiedene vorgegebene Implementierungsalternativen in Frage kommen.

Mit der zuvor beschriebenen Verbindung ist eine Vielzahl von Vorteilen verbunden. Die Erkennung von Multipliziererstrukturen kann ausschließlich durch Beobachtung der Referenzbeschreibung und der in ihr eingebetteten Implementierungen der Multipliziererstrukturen erfolgen. Implementierungsgrenzen sowie Lage der Multipliziererstrukturen in der synthetisierten digitalen Schaltung, welche verifiziert werden soll, müssen nicht bekannt sein. Insbesondere müssen derartige Implementierungsgrenzen in der synthetisierten digitalen Schaltung auch nicht explizit existieren, d.h. diese Grenzen dürfen beispielsweise durch Syntheseoptimierungen mit anderen Schaltungsteilen "verwoben" sein. Gemäß einer bevorzugten Ausführungsform der vorliegenden Erfindung ist eine gleichzeitige Erkennung aller in der synthetisierten digitalen Schaltung enthaltenen Multipliziererstrukturen bzw. Multiplikationsfunktionen möglich. Die Erfindung lässt sich mit einem niedrigen Aufwand realisieren und liefert zur Erkennung der in der digitalen Schaltung verwendeten Implementierungsalternativen für die Multipliziererstrukturen eine hohe Erkennungsrate und eine hohe Erkennungssicherheit. Die für eine Realisierung des erfindungsgemäßen Verfahrens benötigte Laufzeit hängt nur linear von der Größe der zu verifizierenden digitalen Schaltung ab. Wie bereits erwähnt worden ist, kann das erfindungsgemäße Verfahren grundsätzlich auch auf die Erkennung von anderen Schaltungsfunktionen, welche von Multiplikationsfunktionen abweichen, übertragen werden.

Die mit Hilfe der vorliegenden Erfindung gewonnene Information über die in der zu verifizierenden digitalen Schaltung verwendeten Implementierungsvarianten von Multipliziererstrukturen oder anderen bestimmten Schaltungsstrukturen, für welche eine Vielzahl von unterschiedlichen bzw. vordefinierten Implementierungsvarianten in Frage kommen, führt zu einer erheblichen Beschleunigung bei der Äquivalenzprüfung von digitalen Schaltungen, wobei lediglich ein sehr geringer zusätzlicher Rechenaufwand bei der computer- bzw. rechnergestützten Durchführung der Äquivalenzprüfung erforderlich ist. Durch Feststellen der in der digitalen Schaltung verwendeten Implementierungsvarianten und anschließendes Einfügen der erkannten Implementierungsvarianten in die mit der digitalen Schaltung zu vergleichende Referenzbeschreibung kann eine deutlich erhöhte strukturelle Ähnlichkeit zwischen der Referenzbeschreibung und der digitalen Schaltung erzielt werden, wodurch die Laufzeit für das Verifikationsverfahren und der dafür benötigte Speicherbedarf drastisch reduziert werden können. Die Verifikation der Implementierung der Verifikationsfunktionen selbst wird deutlich besser durchführbar, da einerseits die Implementierung der Multiplikationsfunktionen isoliert betrachtet werden kann und andererseits Hinweise über Art und Aufbau dieser Implementierungen bekannt sind. Das erfindungsgemäße Verfahren arbeitet in der Praxis selbst dann noch robust und genau, wenn durch Syntheseoptimierungen Teile der Schaltung (insbesondere auch Ein-/Ausgänge von Multipliziererstrukturen) nicht mehr auffindbar sind.

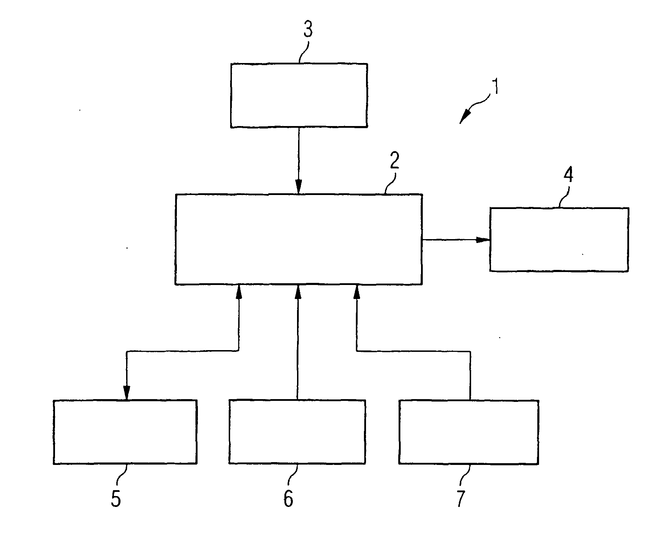

Die vorliegende Erfindung wird nachfolgend näher unter Bezugnahme auf die beigefügte Zeichnung anhand eines bevorzugten Ausführungsbeispiels betreffend die computergestützte Verifikation einer digitalen Schaltung mit Multipliziererstrukturen bzw. Multiplikationsfunktionen beschrieben, wobei die nachfolgend erläuterten Schritte zur Erkennung der für diese Multipliziererstrukturen verwendeten Implementierungsalternativen in der digitalen Schaltung und zur Durchführung einer Äquivalenzprüfung mit einer entsprechend geänderten Referenzbeschreibung wie beschrieben grundsätzlich auch auf andere Schaltungsstrukturen, für welche mehrere unterschiedliche vordefinierte oder vorgegebene Implementierungsvarianten möglich sind, anwendbar sind.

In der einzigen Figur ist eine erfindungsgemäße Vorrichtung 1 zur computergestützten Verifikation von digitalen Schaltungen dargestellt. Die Vorrichtung 1 umfasst als zentralen Bestandteil eine programmgesteuerte Steuereinrichtung 2, welche durch ein in einem Programmspeicher 3 gespeichertes Computerprogramm, das beispielsweise über einen austauschbaren Datenträger kommen wie z.B. Diskette oder CD-ROM, geladen worden ist, zur Durchführung eines automatisierten Verifikationsverfahrens gesteuert wird. Die Steuereinrichtung 2 greift darüber hinaus auf einen Speicher 5 zu, in dem eine Referenzbeschreibung einer digitalen Schaltung, beispielsweise eine RTL-, VHDL- oder Verilog-Beschreibung, gespeichert ist. Diese Referenzbeschreibung dient zur Entwicklung einer entsprechenden digitalen Schaltung, deren realisierte Implementierung z.B. in Form einer VHDL-, Verilog- oder Gatternetzliste-Beschreibung etc. in einem weiteren Speicher 6 gespeichert ist, auf den die Steuereinrichtung 2 zugreifen kann. Des Weiteren ist ein Speicher 7 vorgesehen, in dem in Abhängigkeit von dem für die Entwicklung der digitalen Schaltung zur Verfügung stehenden Synthesetool die von diesem Synthesetool zur Verfügung gestellten Implementierungsalternativen für (ganzzahlige) Multiplikationsfunktionen der digitalen Schaltung gespeichert sind. Wie bereits zuvor erläutert worden ist, lässt sich grundsätzlich jede Multiplikationsfunktion oder Multipliziererstruktur auf unterschiedlichste Art und Weise und insbesondere auch in unterschiedlichen Architekturen implementieren.

Durch Zugriff auf die in den Speichern 5-7 gespeicherten Informationen sind somit der Steuereinrichtung 2 die zu verifizierende Implementierung der digitalen Schaltung (z.B. in Form einer Gatternetzliste), die damit mittels einer Äquivalenzprüfung zu vergleichende Referenzbeschreibung der digitalen Schaltung (z.B. in Form einer RTL-Beschreibung), die verschiedenen vordefinierten und zur Verfügung stehenden Implementierungsalternativen für Multiplikationsfunktionen oder Multipliziererstrukturen (z.B. abhängig von den von den jeweiligen Synthesetool zur Verfügung gestellten Architekturen) und die Lage/Einbettung der Multipliziererstrukturen in der Referenzbeschreibung bekannt. Mit Hilfe dieser Informationen kann die Steuereinrichtung 2 die nachfolgend näher beschriebene Äquivalenzprüfung der Implementierung der digitalen Schaltung durchführen. Die zuvor beschriebenen und in den Speichereinrichtungen 5-7 gespeicherten Informationen sind beispielsweise in einem Standard-Syntheseflow ohnehin verfügbar. Der Steuereinrichtung 2 müssen jedoch beispielsweise nicht die Lage/ Einbettung sowie die Art der Multipliziererstrukturen in der zu verifizierenden Implementierung der digitalen Schaltung bekannt sein.

Die Steuereinrichtung 2 entscheidet mit Hilfe dieser gegebenen Informationen, welche der vordefinierten Implementierungsalternativen für die einzelnen Multiplikationsfunktionen der Referenzbeschreibung in der Implementierung der digitalen Schaltung verwendet werden. Hierzu simuliert die Steuereinrichtung 2 die verschiedenen Implementierungsalternativen aller Multiplikationsfunktionen parallel innerhalb ihrer Einbettung in der Referenzbeschreibung und vergleicht das Simulationsergebnis jeweils mit der entsprechenden Simulation der zu verifizierenden Implementierung der digitalen Schaltung. Dabei wird für jede Implementierungsalternative jeder Multiplikationsfunktion der Referenzbeschreibung der Übereinstimmungsgrad mit der Implementierung der digitalen Schaltung ermittelt. Dieser Übereinstimmungsgrad wird definiert als die Anzahl aller Übereinstimmungspunkte der jeweiligen Implementierungsalternative, wobei ein Übereinstimmungspunkt wiederum ein (interner) Berechnungspunkt der jeweiligen Implementierungsalternative ist, der für alle durchgeführten Simulationsmuster die gleichen Werte berechnet wie ein (beliebiger, aber fester) Berechnungspunkt der Implementierung der digitalen Schaltung. Die Steuereinrichtung 2 ermittelt auf diese Art und Weise für jede Multiplikationsfunktion der Referenzbeschreibung diejenige Implementierungsalternative, welche den größten Übereinstimmungsgrad mit der Simulation der implementierten digitalen Schaltung besitzt. Die Berechnung des Übereinstimmungsgrads kann abhängig von der Größe der zu vergleichenden Schaltungen mittels Äquivalenz-Klassenverfeinerung in linearer Zeit durchgeführt werden.

Mit diesem Wissen lässt sich die Verifikationsaufgabe erheblich vereinfachen. Dazu werden von der Steuereinrichtung 2 in der Referenzbeschreibung der digitalen Schaltung die für jede Multiplikationsfunktion bzw. Multipliziererstruktur ermittelte Implementierungsalternative an die Stelle dieser Multiplikationsfunktion (z.B. RTL-Multiplikationsfunktion) eingesetzt und anschließend mit der auf dieser Art und Weise modifizierten Referenzbeschreibung der Äquivalenzvergleich mit der zu verifizierenden Implementierung der digitalen Schaltung durchgeführt. Aufgrund der dadurch erzielten hohen strukturellen Übereinstimmung zwischen der modifizierten Referenzbeschreibung einerseits und der Implementierung der digitalen Schaltung andererseits kann die nachfolgende Äquivalenzprüfung erheblich beschleunigt werden. Im Idealfall besteht bzgl. der Multiplikationen sogar eine vollständige Übereinstimmung zwischen den beiden Schaltungsbeschreibungen, was die Äquivalenzprüfung erheblich vereinfacht. In der Praxis kann zumindest ein sehr hohes Maß an struktureller Übereinstimmung erzielt werden.

Abschließend können die in der Referenzbeschreibung für die Multiplikationsfunktionen bzw. Multipliziererstrukturen eingesetzten Implementierungsalternativen auch mit spezialisierten Verfahren separat, d.h. isoliert, verifiziert werden.

Die Ergebnisse der Äquivalenzprüfung werden über eine Ausgabeeinheit 4 ausgegeben und somit z.B. auf einem Bildschirm visualisiert.

Die zuvor beschriebene parallele Simulation aller Implementierungsalternativen der Multiplikationsfunktionen/Multipliziererfunktionen kann technisch sehr einfach realisiert werden. So ist es beispielsweise möglich, korrespondierende primäre Eingänge der Multipliziererstrukturen miteinander zu verbinden und die korrespondierenden primären Ausgänge funktionserhaltend, d.h. ohne Verfälschung des Multiplikationsergebnisses jeder einzelnen Multipliziererstruktur, auf einen gemeinsamen Ausgang zu führen, was beispielsweise mit Hilfe einer logischen ODER-Verknüpfung geschehen kann. Des Weiteren kann für die Simulation der Implementierungsalternativen sowie der digitalen Schaltungsbeschreibung eine herkömmliche Random-Pattern-Simulation verwendet werden.

Dem oben beschriebenen Verfahren zur Erkennung der verschiedenen Implementierungsalternativen von Multipliziererstrukturen in der digitalen Schaltungsbeschreibung kommt eine wichtige Bedeutung bei der Beschleunigung der Syntheseverifikation, d.h. bei einem Vergleich einer RTL-Beschreibung mit der daraus synthetisierten Gatternetzliste, zu. Die Laufzeit als auch der Speicherbedarf von Werkzeugen (Tools) zum formalen Schaltungsvergleich hängen erheblich davon ab, wie hoch das Maß der Übereinstimmungen zwischen den zu vergleichenden Schaltungen bzw. den entsprechenden Schaltungsbeschreibungen ist. Dieses Übereinstimmungsmaß lässt sich ausdrücken als die Anzahl der Paare interner Berechnungspunkte aus den beiden Schaltungen, die übereinstimmende Funktionen berechnen. Mit den oben beschriebenen Verfahren lässt sich eine sehr gute Erkennungsrate für die realisierten Implementierungsalternativen von Multiplizierstrukturen erzielen. Zugleich zeichnet sich dieses Verfahren dadurch aus, dass zur Unterscheidung unterschiedlicher Implementierungsalternativen nur wenige Simulationen benötigt werden und dadurch auch der zusätzliche Laufzeitbedarf des Verfahrens äußerst niedrig ist.

Experimentelle Ergebnisse des erfindungsgemäßen Verfahrens sind durchweg äußerst positiv verlaufen. So wurde für eine Erkennung von 21 unterschiedlichen Multipliziererimplementierungen (mit einer unterschiedlichen Bitbreite und auch mit unterschiedlichen Architekturen) lediglich eine Laufzeit von ca. zwei Minuten benötigt. Für jede Multipliziererstruktur standen vier Implementierungsalternativen zur Auswahl. In allen Fällen wurde die korrekte Implementierungsalternative erkannt. Bei den korrekten Implementierungsalternativen wurde eine Übereinstimmung der internen Berechnungspunkte von 50-60 % ermittelt, während die falschen Implementierungsalternativen durch das Verfahren lediglich mit einer Übereinstimmung von 10-20 % bewertet wurden. Dabei wurden lediglich 1024 Simulationen (Simulations-Stimuli) berechnet. Der sich anschließende Verifikationsschritt (Äquivalenzprüfung) konnte mit Hilfe dieser Informationen erheblich beschleunigt und nach ca. 45 Minuten abgeschlossen werden. Bei konventioneller Vorgehensweise, d.h. ohne Erkennung der Implementierungsalternativen für die Multipliziererstrukturen mit anschließender separater Verifikation, wurde eine Laufzeit von über 24 Stunden benötigt.

Zusammenfassend lässt sich somit festhalten, dass eine Erkennung der verwendeten Implementierungsalternativen der Multipliziererstrukturen mit sehr hoher Sicherheit bei nahezu vernachlässigbarem Zusatzaufwand möglich ist und zu einer deutlichen Beschleunigung der formalen Verifikation von digitalen Schaltungen führt.

## Patentansprüche

1. Verfahren zur Verifikation von digitalen Schaltungen,
wobei eine zu verifizierende digitale Schaltung (6) mit einer Referenzbeschreibung (5) der digitalen Schaltung verglichen wird, um durch eine Äquivalenzprüfung Fehler in der digitalen Schaltung zu erkennen,
**dadurch gekennzeichnet**,
(a) dass für bestimmte durch die Referenzbeschreibung (5) der digitalen Schaltung beschriebene Schaltungsstrukturen, für welche verschiedene Implementierungsalternativen (7) bekannt sind, jeweils diejenige Implementierungsalternative (7) bestimmt wird, welche den größten strukturellen Übereinstimmungsgrad mit der zu verifizierenden digitalen Schaltung (6) aufweist,
wobei die verschiedenen Implementierungsalternativen (7) jeweils in Kombination mit der Referenzbeschreibung (5) simuliert und mit einer entsprechenden Simulation der digitalen Schaltung (6) verglichen werden, um als die Implementierungsalternative (7) mit dem größten strukturellen Übereinstimmungsgrad mit der digitalen Schaltung (6) diejenige Implementierungsalternative (7) zu bestimmen, welche dabei für mehrere Simulationsmuster die größte Übereinstimmung von Berechnungspunkten mit der digitalen Schaltung (7) aufweist,
(b) dass in der Referenzbeschreibung (5) der digitalen Schaltung die Beschreibung der einzelnen Schaltungsstrukturen durch die für die jeweilige Schaltungsstruktur im Schritt (a) ermittelte Implementierungsalternative (7) mit dem jeweils größten strukturellen Übereinstimmungsgrad ersetzt wird, und (c) dass die Äquivalenzprüfung durch Vergleich der digitalen Schaltung (6) mit der gemäß Schritt (b) geänderten Referenzbeschreibung (5) durchgeführt wird.

2. Verfahren nach Anspruch 1,
**dadurch gekennzeichnet,**
**dass** die bestimmten Schaltungsstrukturen, für welche im Schritt (a) jeweils die Implementierungsalternative mit dem größten Übereinstimmungsgrad ermittelt wird, Multipliziererstrukturen sind.

3. Verfahren nach Anspruch 2,
**dadurch gekennzeichnet,**
**dass** die bestimmten Schaltungsstrukturen, für die im Schritt (a) jeweils die Implementierungsalternative (7) mit dem größten Übereinstimmungsgrad ermittelt wird, Multipliziererstrukturen zur Realisierung ganzzahliger Multiplikationsfunktionen sind.

4. Verfahren nach einem der vorhergehenden Ansprüche,
**dadurch gekennzeichnet,**
**dass** das Verfahren computergestützt durchgeführt wird.

5. Verfahren nach einem der vorhergehenden Ansprüche,
**dadurch gekennzeichnet,**
**dass** die Referenzbeschreibung (5) ausgewählt ist aus einer RTL-, VHDL- und Verilog-Schaltungsbeschreibungen umfassenden Gruppe.

6. Verfahren nach einem der vorhergehenden Ansprüche,
**dadurch gekennzeichnet,**
**dass** im Schritt (c) die Äquivalenzprüfung durch einen Vergleich einer vorliegenden Implementierung der digitalen Schaltung (6) mit der im Schritt (b) geänderten Referenzbeschreibung (5) durchgeführt wird.

7. Verfahren nach einem der vorhergehenden Ansprüche,
**dadurch gekennzeichnet,**
**dass** die vorgegebenen Implementierungsalternativen (7) für die bestimmten Schaltungsstrukturen verschiedene von einer für den Entwurf der digitalen Schaltung vorhandenen Syntheseeinrichtung unterstützte Architekturen dieser bestimmten Schaltungsstrukturen umfassen.

8. Verfahren nach einem der vorhergehenden Ansprüche,
**dadurch gekennzeichnet,**
**dass** im Schritt (a) für jede Schaltungsstruktur die verschiedenen Implementierungsalternativen (7) gleichzeitig simuliert und mit der Simulation der digitalen Schaltung (6) verglichen werden.

9. Verfahren nach Anspruch 8,
**dadurch gekennzeichnet,**
**dass** die verschiedenen Implementierungsalternativen (7) für jede Schaltungsstruktur **dadurch** gleichzeitig simuliert werden, dass Eingänge der Implementierungsalternativen (7) miteinander verbunden und korrespondierende Ausgänge der Implementierungsalternativen (7) unter Beibehaltung der Schaltungsfunktion der einzelnen Implementierungsalternativen auf einen gemeinsamen Ausgang geführt werden.

10. Verfahren nach Anspruch 9,
**dadurch gekennzeichnet,**
**dass** die Ausgänge der verschiedenen Implementierungsalternativen (7) über eine logische ODER-Schaltungseinrichtung mit dem gemeinsamen Ausgang verbunden werden.

11. Verfahren nach einem der vorhergehenden Ansprüche,
**dadurch gekennzeichnet,**
**dass** im Schritt (a) für jede Implementierungsalternative (7) der Übereinstimmungsgrad mit der Simulation der digitalen Schaltung (6) **dadurch** ermittelt wird, dass für die mehreren Simulationsmuster für jede Implementierungsalternative (7) die Anzahl der für die einzelnen Simulationsmuster von der Referenzbeschreibung (5) mit der jeweiligen Implementierungsalternative ausgegebenen Werte, die identisch alternative ausgegebenen Werte, die identisch zu den von der digitalen Schaltung (6) für die entsprechenden Simulationsmuster ausgegebenen Werte sind, ermittelt und als Übereinstimmungsgrad für die entsprechende Implementierungsalternative (7) verwendet wird.

12. Verfahren nach einem der vorhergehenden Ansprüche,
**dadurch gekennzeichnet,**
**dass** bei der im Schritt (a) durchgeführten Bestimmung der Implementierungsalternativen (7) mit dem größten strukturellen Übereinstimmungsgrad ein Verfahren einer Äquivalenzklassenverfeinerung angewendet wird.

13. Vorrichtung zur Verifikation von digitalen Schaltungen, mit ersten Speichermitteln (6) zum Speichern einer Beschreibung einer zu verifizierenden digitalen Schaltung,
mit zweiten Speichermitteln (5) zum Speichern einer Referenzbeschreibung der digitalen Schaltung, und
mit Verifikationsmitteln (2), welche derart eingerichtet sind, dass sie die Beschreibung der zu verifizierenden digitalen Schaltung (6) mit der Referenzbeschreibung (5) vergleichen, um durch eine Äquivalenzprüfung Fehler in der digitalen Schaltung zu erkennen,
**dadurch gekennzeichnet,**
**dass** dritte Speichermittel (7) zum Speichern verschiedener vorgegebener Implementierungsalternativen für bestimmte Schaltungsstrukturen der digitalen Schaltung vorgesehen sind, dass die Verifikationsmittel (2) derart eingerichtet sind, dass sie für die bestimmten Schaltungsstrukturen jeweils diejenige Implementierungsalternative bestimmen, welche den größten strukturellen Übereinstimmungsgrad mit der zu verifizierenden digitalen Schaltung aufweist,
wobei die Verifikationsmittel (2) derart eingerichtet sind, dass sie zur Bestimmung der Implementierungsalternative mit dem größten strukturellen Übereinstimmungsgrad mit der digitalen Schaltung die verschiedenen Implementierungsalternativen jeweils in Kombination mit der Referenzbeschreibung simulieren und mit einer entsprechenden Simulation der digitalen Schaltung vergleichen, um als die Implementierungsalternative mit dem größten strukturellen Übereinstimmungsgrad mit der digitalen Schaltung diejenige Implementierungsalternative zu bestimmen, welche dabei für mehrere Simulationsmuster die größte Übereinstimmung von Berechnungspunkten mit der digitalen Schaltung aufweist, und
**dass** die Verifikationsmittel (2) derart eingerichtet sind, dass sie in der Referenzbeschreibung der digitalen Schaltung für die einzelnen bestimmten Schaltungsstrukturen jeweils die zuvor ermittelte Implementierungsalternative mit dem größten strukturellen Übereinstimmungsgrad einsetzen und die zu verifizierende Beschreibung der digitalen Schaltung mit der somit geänderten Referenzbeschreibung zur Durchführung der Äquivalenzprüfung vergleichen.

14. Vorrichtung nach Anspruch 13,
**dadurch gekennzeichnet,**
**dass** die Vorrichtung zur Durchführung des Verfahren nach einem der Ansprüche 1-12 eingerichtet ist.

15. Computerprogramm-Produkt mit einem auf einem Datenträger (3) gespeicherten Programmcode zur Durchführung des Verfahrens nach einem der Ansprüche 1-12, wenn der Programmcode in einem Rechnersystem (1) abläuft.

16. Digitales Speichermedium (3) mit elektronisch auslesbaren Steuersignalen, die so mit einem Rechnersystem zusammenwirken können, dass das Verfahren nach einem der Ansprüche 1-12 ausgeführt wird.

## Claims

1. Process for the verification of digital circuits, wherein a digital circuit (6) to be verified is compared with a reference description (5) of the digital circuit, in order to detect by an equivalence test errors in the digital circuit,
**characterised in that**
(a) for specific circuit structures described by the reference description (5) of the digital circuit, for which different implementation alternatives (7) are known, the implementation alternative (7) is determined, respectively, having the highest degree of structural similarity with the digital circuit (6) to be verified,
wherein the different implementation alternatives (7) are simulated in combination with the reference description (5) and compared with a corresponding simulation of the digital circuit (6), respectively, in order to determine the implementation alternative (7) having the highest degree of structural similarity with the digital circuit (6), which has for several simulation patterns the highest similarities of design points with the digital circuit (6),
(b) the description of the individual circuit structures is replaced in the reference description (5) of the digital circuit by the implementation alternative (7) determined for the respective circuit structure in step (a) with the respective highest degree of structural similarity, and
(c) the equivalence test is carried out by comparing the digital circuit (6) with the reference description (5) changed according to step (b).

2. Process according to Claim 1, **characterised in**
**that** the specific circuit structures, for which in step (a) the implementation alternative with the highest degree of similarity is determined, respectively, are multiplier structures.

3. Process according to Claim 2, **characterised in**
**that** the specific circuit structures, for which the implementation alternative (7) with the highest degree of similarity is determined in step (a), respectively, are multiplier structures for realizing integer multiplication functions.

4. Process according to any one of the preceding claims, **characterised in that**
the process is carried out aided by a computer.

5. Process according to any one of the preceding claims, **characterised in that**
the reference description (5) is selected from a group comprising RTL-, VHDL- and Verilog-circuit descriptions.

6. Process according to any one of the preceding claims, **characterised in that** the equivalence test in step (c) is carried out by comparing a provided implementation of the digital circuit (6) with the reference description (5) changed in step (b).

7. Process according to any one of the preceding claims, **characterised in that**
the given implementation alternatives (7) for the specific circuit structures comprise several architectures of these specific circuit structures supported by a synthesis device existing for the design of the digital circuit.

8. Process according to any one of the preceding claims, **characterised in that**
the different implementation alternatives (7) in step (a) are for each circuit structure at the same time simulated and compared with the simulation of the digital circuit (6).

9. Process according to Claim 8, **characterised in that**
the different implementation alternatives (7) for each circuit structure are simulated at the same time by connecting inputs of the implementation alternatives (7) with each other and applying corresponding outputs of the implementation alternatives (7) to a common output while maintaining the circuit function of the individual implementation alternatives.

10. Process according to Claim 9, **characterised in that**
the outputs of the different implementation alternatives (7) are connected by a logic OR element to the common output.

11. Process according to any one of the preceding claims, **characterised in that**
for each implementation alternative (7) in step (a) the degree of similarity with the simulation of the digital circuit (6) is obtained in the way, that, for the several simulation patterns for each implementation alternative (7), the number of the values put-out for the individual simulation patterns of the reference description (5) with the respective implementation alternative, being the identical alternatively put-out values, which are identical to the values put-out by the digital circuit (6) for the corresponding simulation patterns, is determined and is used as degree of similarity for the corresponding implementation alternative (7).

12. Process according to any one of the preceding claims, **characterised in that**
a process of equivalence class refinement is applied in the determination of the implementation alternatives (7) with the highest degree of structural similarity carried out in step (a).

13. Device for the verification of digital circuits,
with first memory means (6) for storing a description of a digital circuit to be verified, with second memory means (5) for storing a reference description of the digital circuit, and
with verification means (2), which are set up in such a manner that they compare the description of the digital circuit (6) to be verified with the reference description (5), in order to detect by an equivalence test errors in the digital circuit,
**characterised in**
**that** third memory means (7) are provided for storing different given implementation alternatives for specific circuit structures of the digital circuit,
**that** the verification means (2) are set up in such a manner that they determine for each of the specific circuit structures that implementation alternative, respectively, having the highest degree of structural similarity with the digital circuit to be verified,
wherein the verification means (2) are set up in such a manner that they simulate, for the determination of the implementation alternative with the highest degree of structural similarity with the digital circuit, the different implementation alternatives in combination with the reference description, respectively, and compare these with a corresponding simulation of the digital circuit, in order to determine the implementation alternative with the highest degree of structural similarity with the digital circuit that implementation alternative, that is having for several simulation patterns the highest similarities of design points with the digital circuit, and
**that** the verification means (2) are set up in such a manner that they insert the previously determined implementation alternative with the highest degree of structural similarity into the reference description of the digital circuit for the individual specific circuit structures, respectively, and compare the description of the digital circuit to be verified with the thus changed reference description for carrying out the equivalence test.

14. Device according to Claim 13, **characterised in that**
the device is set up for carrying out the process according to any one of Claims 1-12.

15. Computer-program product with a program-code stored on a data medium (3), for carrying out the process according to any one of Claims 1-12, whenever the program-code is run in a computer system (1).

16. Digital storage medium (3) with electronically readable control signals, which can cooperate with a computer system, so that the process is carried out according to any one of Claims 1-12.

## Revendications

1. Procédé de vérification de circuits numériques, dans lequel un circuit numérique (6) à vérifier est comparé à une description de référence (5) du circuit numérique, afin d'identifier des erreurs dans le circuit numérique par un test d'équivalence, **caractérisé en ce que**,
(a) pour des structures de circuit spécifiques, décrites à travers la description de référence (5) du circuit numérique, pour lesquelles différentes alternatives d'implémentation (7) sont connues, l'alternative d'implémentation (7) est définie respectivement comme celle qui présente le plus haut degré de conformité structurelle avec le circuit numérique à vérifier,
les différentes alternatives d'implémentation (7) étant simulées en combinaison avec la description de référence (5), et comparées avec la simulation correspondante du circuit numérique (6), respectivement, pour définir en tant qu'alternative d'implémentation avec le plus grand degré de conformité structurelle avec le circuit numérique (6), l' alternative d'implémentation (7) qui présente, parmi plusieurs types de simulation, la plus grande conformité de points de calculs avec le circuit numérique (6),
(b) dans la description de référence (5) du circuit numérique, la description des structures de circuit respectives est remplacée par l'alternative d'implémentation (7) évaluée respectivement à l'étape (a) pour une structure respective de circuit, avec respectivement le plus haut degré de conformité structurelle, et
(c) le test d'équivalence est conduit à travers la comparaison du circuit numérique (6) avec la description de référence (5) modifiée à l'étape (b).

2. Procédé selon la revendication 1, **caractérisé en ce que** les structures de circuit spécifiques, pour lesquelles l'alternative d'implémentation avec le plus haut degré de conformité structurelle est déterminée respectivement à l'étape (a), sont des structures multiples.

3. Procédé selon la revendication 2, **caractérisé en ce que** les structures de circuit spécifiques, pour lesquelles l'alternative d'implémentation (7) avec le plus haut degré de conformité structurelle est déterminée respectivement à l'étape (a), sont des structures multiples pour réaliser des fonctions de multiplication d'entiers.

4. Procédé selon l'une quelconque des revendications précédentes, **caractérisé en ce que** le procédé est réalisé à l'aide d'ordinateur.

5. Procédé selon l'une quelconque des revendications précédentes, **caractérisé en ce que** la description de référence (5) est choisie parmi un groupe comprenant des descriptions de circuit RTL, VHDL et Verilog.

6. Procédé selon l'une quelconque des revendications précédentes, **caractérisé en ce que** le test d'équivalence à l'étape (c) est réalisé à l'aide d'une comparaison d'une implémentation fournie du circuit numérique (6) avec la description de référence (5) modifiée à l'étape (b).

7. Procédé selon l'une quelconque des revendications précédentes, **caractérisé en ce que** les alternatives d'implémentation (7) données pour les structures de circuit spécifiques comprennent différentes architectures de ces structures de circuit spécifiques, supportées par un dispositif de synthèse existant pour la conception du circuit numérique.

8. Procédé selon l'une quelconque des revendications précédentes, **caractérisé en ce que**, à l'étape (a), les différentes alternatives d'implémentation (7) pour chaque structure de circuit sont simulées, et sont comparées à la simulation du circuit numérique (6) en même temps.

9. Procédé selon la revendication 8, **caractérisé en ce que** les différentes alternatives d'implémentation (7) pour chaque structure de circuit sont simulées en même temps, en connectant des entrées des alternatives d'implémentation (7) les unes avec les autres, et en appliquant les sorties correspondantes des alternatives d'implémentation (7) à une sortie commune, tout en maintenant la fonction de circuit des alternatives d'implémentation individuelles.

10. Procédé selon la revendication 9, **caractérisé en ce que** les sorties des différentes alternatives d'implémentation (7) sont connectées à une sortie commune, par un élément logique OR.

11. Procédé selon quelconque des revendications précédentes, **caractérisé en ce que**, à l'étape (a), pour chaque alternative d'implémentation (7), le degré de conformité avec la simulation du circuit numérique (6) est obtenu, **en ce que**, pour différents modèles de simulation pour chaque alternative d'implémentation (7), le nombre de valeurs sorties pour les modèles de simulation individuels de la description de référence (5) avec l'alternative d'implémentation respective, les valeurs sorties étant des valeurs sorties alternatives identiques, qui sont identiques aux valeurs sorties par le circuit numérique (6) pour les modèles de simulation correspondants, est déterminé et utilisé comme degré d'équivalence pour l'alternative d'implémentation (7) correspondante.

12. Procédé selon quelconque des revendications précédentes, **caractérisé en ce que** un procédé d'amélioration de classe d'équivalence est appliqué dans la détermination réalisée à l'étape (a) des alternatives d'implémentation (7) avec le plus haut degré de conformité structurelle.

13. Dispositif pour la vérification de circuits numériques,
avec des premiers moyens de stockage (6) pour stocker une description d'un circuit numérique à vérifier,
avec des deuxièmes moyens de stockage (5) pour stocker une description de référence du circuit numérique, et
avec des moyens de vérification (2), qui sont disposés de sorte qu'ils comparent la description du circuit numérique (6) à vérifier avec la description de référence (5), afin d'identifier des erreurs dans le circuit numérique par un test d'équivalence,
**caractérisé en ce que**
des troisièmes moyens de stockage (7) pour stocker différentes alternatives d'implémentation pour les structures spécifiques de circuit numérique sont prévus, que les moyens de vérification (2) sont disposés de sorte qu'ils déterminent respectivement, pour les structures de circuits spécifiques, l'alternative d'implémentation qui présente le plus haut degré de conformité structurelle avec le circuit numérique à vérifier,
les moyens de vérification (2) étant disposés de sorte de simuler, pour la détermination de l'alternative d'implémentation avec le plus haut degré de conformité structurelle avec le circuit numérique, respectivement les différentes alternatives d'implémentation en combinaison avec la description de référence, et de comparer à une simulation correspondante du circuit numérique, afin de déterminer comme alternative d'implémentation avec le plus haut degré de conformité structurelle avec le circuit numérique l'alternative d'implémentation qui présente la plus grande conformité de points de calculs avec le circuit numérique pour plusieurs modèles de simulation, et
les moyens de vérification (2) sont disposés de sorte d'introduire, dans la description de référence du circuit numérique pour les structures de circuit définies individuelles, respectivement l'alternative d'implémentation déterminée au préalable avec le plus haut degré de conformité structurelle, et de comparer la description du circuit numérique à vérifier avec la description de référence ainsi modifiée, pour réaliser un test d'équivalence.

14. Dispositif selon la revendication 13, **caractérisé en ce que**
le dispositif est arrangé pour la réalisation du procédé selon l'une quelconque des revendications 1-12.

15. Logiciel d'ordinateur avec un code de programme sauvegardé sur un support de données (3), pour la réalisation du procédé selon l'une des revendications 1-12, lorsque le code du programme tourne dans un système d'ordinateur (1).

16. Support de stockage numérique (3) avec des signaux de contrôle lisibles électroniquement, qui peuvent coopérer avec un système d'ordinateur de sorte que le procédé selon l'une quelconque des revendications 1-12 est réalisé.
